# EUROPÄISCHE PATENTSCHRIFT

(11) **EP 3 114 711 B1**
(45) Veröffentlichungstag und Bekanntmachung des Hinweises auf die Patenterteilung: **11.01.2023**
(21) Anmeldenummer: 15703865.4
(22) Anmeldetag: 26.01.2015
(51) Int. Cl.: H01L 29/861, H01G 7/02, H01L 29/93, H01L 27/11507, H01L 49/02, H01L 27/10, H01L 27/102

(54) **DETEKTOR MIT EINER KAPAZITÄTSDIODE**
DETECTOR COMPRISING A VARICAP DIODE
DÉTECTEUR ÉQUIPÉ D'UN DIODE VARICAP

(30) Priorität: 07.03.2014 DE 102014003039; 22.04.2014 DE 102014105639
(43) Veröffentlichungstag der Anmeldung: 11.01.2017
(73) Patentinhaber: Helmholtz-Zentrum Dresden - Rossendorf e.V., 01328 Dresden (DE)
(72) Erfinder: SCHMIDT, Heidemarie, 01187 Dresden (DE); SKORUPA, Ilona, 01108 Dresden (DE); PRUCNAL, Slawomir, 01328 Dresden (DE); BÜRGER, Danilo, 01219 Dresden (DE); BOGUSZ, Agnieska, 09599 Freiberg (DE); SELVARAJ, Laveen, 09126 Chemnitz (DE)
(86) Internationale Anmeldenummer: PCT/DE2015/100029
(87) Internationale Veröffentlichungsnummer: WO 2015/131877

(56) Entgegenhaltungen:
- WO-A1-2011/129766
- WO-A1-2011/129766
- US-A1- 2007 138 522
- US-A1- 2007 138 522
- US-A1- 2008 107 885
- ZHENG X ET AL: "Evaluation of capacitance-voltage characteristic and memory window of metal-ferroelectric-insulator-silicon capacitors", APPLIED PHYSICS LETTERS, AMERICAN INSTITUTE OF PHYSICS, US, Bd. 93, Nr. 21, 24. November 2008 (2008-11-24), Seiten 213501-213501, XP012112641, ISSN: 0003-6951, DOI: 10.1063/1.3021015
- TIANGUI YOU ET AL: "Exploiting Memristive BiFeO 3 Bilayer Structures for Compact Sequential Logics", ADVANCED FUNCTIONAL MATERIALS, Bd. 24, Nr. 22, 24. Februar 2014 (2014-02-24), Seiten 3357-3365, XP055184900, ISSN: 1616-301X, DOI: 10.1002/adfm.201303365

## Beschreibung

Die Erfindung betrifft einen Detektor zur Strahlungserfassung mit mindestens einer Kapazitätsdiode; wobei die Kapazitätsdiode ein Mehrschichtsystem aufweist.

Kapazitätsdioden ermöglichen eine Variation ihrer Kapazität mittels Anlegens einer elektrischen Spannung, wobei Kapazitätsdioden z.B. mittels eines Mehrschichtsystems aus unterschiedlich dotierten Halbleitermaterialien aufgebaut sein können.

Als ein anderes Beispiel weisen Mehrschichtsysteme bestehend aus einem Isolator und einem dotierten Halbleiter, z.B. SiO₂ auf p-leitendem Silizium, mit einem Metallkontakt am Isolator und einem Metallkontakt am dotierten Halbleiter, eine von den dielektrischen Eigenschaften des Isolators und der Raumladungszone im dotierten Halbleiter an der Grenze zwischen dem Isolator und dem dotierten Halbleiter abhängige Kapazität auf. Diese Kapazität kann durch Anlegen einer Spannung von außen an den Metallkontakt am Isolator und den Metallkontakt am dotierten Halbleiter kontrolliert werden. Im Isolator, an der Grenzfläche zwischen Isolator und dotiertem Halbleiter, und im dotierten Halbleiter können sich Defekte ausbilden. Wegen dieser Defekte hängt die mit einer Wechselspannung einer Testfrequenz f_{ac} gemessene Kapazität des Mehrschichtsystems von der Testfrequenz f_{ac} ab. Bei Bestrahlung mit Licht mit einer Energie größer als die elektronische Bandlücke E_{g} des dotierten Halbleiters wird die Ausdehnung der Raumladungszone im dotierten Halbleiter verringert und die Kapazität des Mehrschichtsystems erhöht.

Des Weiteren werden Metall-Isolator-Halbleiter-Strukturen in Charge Coupled Devices (CCD) und in Festkörperbildsensoren verwendet. Detektiert wird eine Ladungsanhäufung im dotierten Halbleiter aufgrund photogenerierter Ladungsträger bei Bestrahlung mit Licht. Aufgrund der kontinuierlichen Umverteilung der Defekte in Metall-Isolator-Halbleiter-Strukturen ist die Kapazität der Metall-Isolator-Halbleiter-Strukturen bei Bestrahlung nicht stabil und kann nicht als Detektionssignal in CCDs und Festkörperbildsensoren verwendet werden.

Feldeffekt-Transistoren mit einem ferroelektrischen Dielektrikum können als ferroelektrische Speicher verwendet werden, wobei der Source-Drain-Stromwert als Auslesewert der gespeicherten Information dient. Aufgrund von Leckströmen durch das ferroelektrische Dielektrikum degradiert jedoch der Polarisationszustand des ferroelektrischen Dielektrikums, sodass ein derartiger Speicher relativ flüchtig ist.

Die US 5 524 092 A beschreibt Kapazitätsdioden als Speichervorrichtungen, wobei Kapazitätsdioden mit zwei Elektroden und einer dazwischen angeordneten Schichtenfolge mit einer Schicht aus ferroelektrischem Material, Schichten als Haft- und Barriereschicht aus leitenden Metallen oder Siliziumnitrid, und einer Schicht aus einem dotierten Halbleitermaterial behandelt werden.

In "Capacitance-voltage and retention characteristics of Pt/SrBi₂Ta₂O₉/HfO₂/Si structures with various buffer layer thickness" (Tang et al., Applied Physics Letters, Vol. 94, S. 212907, 2009) werden Diodenstrukturen mit der Materialabfolge Metall, SrBi₂Ta₂O₉ als Ferroelektrikum, HfO₂ als Isolator, Halbleiter für unterschiedliche Isolator-Dicken charakterisiert; wobei festgestellt wird, dass Strukturen mit dünneren HfO₂-Schichten hinsichtlich der Retention besser geeignet sind.

Die US 5 751 049 A beschreibt Infrarot-Detektoren mit Metall-Isolator-Halbleiter-Strukturen.

Die US 2008/0107885 A1 beschreibt Mehrschichtanordnungen mit mindestens einer dielektrischen Schicht mit einer Schichtdicke h₂ und mindestens einer ferroelektrischen Schicht mit einer Schichtdicke h₁, wobei die Dielektrizitätskonstante der dielektrischen Schicht einen kritischen Anteil α=h₂/(h₁+h₂) aufweist, und wobei die Schichtanordnung zwischen zwei Elektroden geschaltet sein kann.

In dem Artikel "Evaluation of capacitance-voltage characteristic and memory window of metal-ferroelectric-insulator-silicon capacitors" (X. J. Zheng et al., Applied Physics Letters 93, S. 213501, 2008) werden experimentelle Daten zu Metall-Ferroelektrikum-Isolator-Silizium-Kapazitätsstrukturen mit modellierten Daten verglichen.

In dem Artikel "Exploiting Memristive BiFeO₃ Bilayer Structures for Compact Sequential Logics" (T. You et al., Advanced Functional Materials 24, S. 3357, 2014) werden BiFeO₃:Ti/BiFeO₃-Zweischichtstrukturen elektrisch charakterisiert.

Die WO 2011/129766 A1 beschreibt einen Detektor gemäß dem Oberbegriff von Anspruch 1. Sie beschreibt photovoltaische UV-Detektoren mit einem Schichtsystem mit einer dielektrischen und z.B. ferroelektrischen ersten Schicht sowie einer als Metallschicht oder Halbleiterschicht ausgebildeten zweiten Schicht, wobei die UV-Detektoren zum Erfassen der Photospannung oder des Photostroms ausgebildet sind, die von dem Schichtsystem bei darauf auftreffender Strahlung generiert werden.

Durch die Erfindung wird ein Detektor zum Erfassen von Teilchen- oder Wellenstrahlung mit einer Kapazitätsdiode als sensitivem Element bereitgestellt, insbesondere mit einer unkompliziert aufgebauten Kapazitätsdiode, deren Kapazitätscharakteristik mit einem geringen Energieverbrauch variabel und nichtflüchtig einstellbar ist.

Gemäß der Erfindung wird ein Detektor mit einem elektrischen Bauelement in Form einer Kapazitätsdiode bereitgestellt, d.h. mit einem elektrischen Bauelement mit einer variabel einstellbaren Kapazität. Die Kapazitätsdiode weist eine erste Elektrode und eine zweite Elektrode zum elektrischen Kontaktieren der Kapazitätsdiode auf. Die Kapazitätsdiode weist zudem eine kontaktierend zwischen der ersten und der zweiten Elektrode angeordnete Schichtanordnung auf, wobei die Schichtanordnung in Richtung von der ersten zu der zweiten Elektrode hin nacheinander eine Schicht aus einem ferroelektrischen Material (auch als "ferroelektrische Schicht" bezeichnet) und eine elektrisch isolierende Schicht aus einem dielektrischen Material (auch als "dielektrische Schicht" oder "Isolatorschicht" bezeichnet) aufweist. Die Schicht aus dem dielektrischen Material ist mit elektrisch geladenen Störstellen ausgebildet (d.h. in der Schicht aus dem dielektrischen Material befinden sich elektrisch geladene Störstellen). Das ferroelektrische Material kann z.B. ein multiferroisches Material sein.

Die dielektrische Schicht ist bevorzugt direkt kontaktierend an der ferroelektrischen Schicht angeordnet. Es kann z.B. vorgesehen sein, dass die Schichtanordnung aus der ferroelektrischen Schicht und der dielektrischen Schicht besteht.

Gemäß einer Ausführungsform weist die Schichtanordnung jedoch außerdem eine Schicht aus einem dotierten Halbleitermaterial auf (auch als "Halbleiterschicht" oder "halbleitende Schicht" bezeichnet). Gemäß dieser Ausführungsform ist die dielektrische Schicht zwischen der ferroelektrischen Schicht und der halbleitenden Schicht angeordnet, sodass die Schichtanordnung in Richtung von der ersten zu der zweiten Elektrode hin nacheinander die Schicht aus dem ferroelektrischen Material, die Schicht aus dem dielektrischen Material und die Schicht aus dem dotierten Halbleitermaterial aufweist. Es kann insbesondere vorgesehen sein, dass die Schichtanordnung aus der ferroelektrischen Schicht, der dielektrischen Schicht und der halbleitenden Schicht besteht.

Die Schichtanordnung ist mittels der beiden Elektroden elektrisch kontaktiert, wobei die erste Elektrode kontaktierend an der einen Randschicht der Schichtanordnung angeordnet ist und die zweite Elektrode kontaktierend an der anderen Randschicht der Schichtanordnung angeordnet ist. So kann z.B., je nach Konfiguration der Schichtanordnung, vorgesehen sein, dass die erste Elektrode kontaktierend an der ferroelektrischen Schicht angeordnet ist und die zweite Elektrode (im Falle dass keine halbleitende Schicht vorhanden ist) an der dielektrischen Schicht bzw. (im Falle des Vorhandenseins einer halbleitenden Schicht) an der halbleitenden Schicht angeordnet ist. Die erste Elektrode wird auch als Frontelektrode, Topelektrode oder Frontkontakt bezeichnet. Die zweite Elektrode wird auch als Gegenelektrode, Bottomelektrode, Gegenkontakt oder Bottomkontakt bezeichnet.

Durch Anlegen einer elektrischen Spannung zwischen die beiden Elektroden kann die Richtung der spontanen Polarisation des ferroelektrischen Materials beeinflusst werden. Wenn das elektrische Feld, das durch den Abfall der angelegten Spannung über der ferroelektrischen Schicht hervorgerufen wird, größer ist als die Koerzitivfeldstärke des ferroelektrischen Materials, erfolgt eine im Wesentlichen vollständige Ausrichtung der Polarisation gemäß der Richtung des elektrischen Feldes, wobei die Polarisation des ferroelektrischen Materials durch Umpolen der angelegten Spannung umgepolt werden kann. Derartige Spannungen, die zum Überschreiten der Koerzitivfeldstärke der ferroelektrischen Schicht ausreichen, werden im Folgenden auch als Schalt- oder Schreibspannung bezeichnet.

Es hat sich herausgestellt, dass die Kapazität bzw. Kapazitätscharakteristik der Kapazitätsdiode mit dem Betrag (wobei jedoch der Betrag der Schaltspannung stets zum Überschreiten der Koerzitivfeldstärke der ferroelektrischen Schicht genügt) und der Polarität einer derartigen Schaltspannung nichtflüchtig variiert, d.h. mittels zeitlich begrenzten oder andauernden Anlegens einer derartigen Schaltspannung dauerhaft auf einen von dem Betrag und der Polarität der Schaltspannung abhängigen Wert bzw. Zustand einstellbar ist.

Nach derzeitiger Erkenntnis kann z.B. die in der ferroelektrischen Schicht vorliegende Polarisation die elektrisch geladenen Störstellen in der benachbarten dielektrischen Schicht beeinflussen, wobei diese Störstellen gemäß ihrer Ladung (Betrag und Vorzeichen) unter entsprechender Veränderung des Ladungsschwerpunktes umpositioniert (z.B. ausgerichtet und/oder verschoben) werden. Somit weist z.B. der Ladungsschwerpunkt der elektrisch geladenen Störstellen in der dielektrischen Schicht bei Vorliegen der ersten Polarisationsrichtung eine andere Position auf als bei Vorliegen der zweiten Polarisationsrichtung, wobei diese Variation des Ladungsschwerpunkts mit einer Variation der Kapazität bzw. Kapazitätscharakteristik der Kapazitätsdiode einhergeht (d.h. die Kapazitätsdiode weist bei Vorliegen der beiden Polarisationsrichtungen der ferroelektrischen Schicht unterschiedliche Kapazitäts-Spannungs-Kennlinien auf). Alternativ oder zusätzlich dazu kann die Kapazitätscharakteristik nicht nur über die Variation der Polarität der angelegten Spannung, sondern auch über Variation des Betrages der angelegten Spannung variiert werden.

Somit kann die Kapazitätsdiode durch (temporäres oder dauerhaftes) Anlegen unterschiedlicher Schaltspannungen, wobei diese sich hinsichtlich Betrag und/oder Polarität unterscheiden, nichtflüchtig in unterschiedliche Schaltzustände mit unterschiedlichen Kapazitäten bzw. Kapazitätscharakteristiken versetzt werden. Dabei ist der Betrag einer derartigen Schaltspannung jedoch stets so groß, dass er zum Überschreiten der Koerzitivfeldstärke der ferroelektrischen Schicht genügt (d.h. der Betrag der Schaltspannung ist so groß, dass das elektrische Feld, das bei Beaufschlagung der Elektroden der Kapazitätsdiode mit der Schaltspannung durch den Spannungsabfall über der ferroelektrischen Schicht in derselben hervorgerufen wird, größer ist als die Koerzitivfeldstärke des ferroelektrischen Materials).

Insbesondere kann die Kapazitätsdiode durch Anlegen einer ersten Schaltspannung in einen ersten Schaltzustand und durch Anlegen einer zweiten Schaltspannung in einen zweiten Schaltzustand versetzt werden, wobei der Betrag der ersten und der zweiten Schaltspannung mindestens so groß ist, dass in der Schicht aus dem ferroelektrischen Material die Koerzitivfeldstärke des ferroelektrischen Materials überschritten wird, und wobei die erste Schaltspannung einen anderen Betrag und/oder eine andere Polarität aufweist als die zweite Schaltspannung.

Demgemäß kann die Kapazitätsdiode z.B. durch Anlegen einer ersten Schaltspannung einer ersten Polarität in einen ersten Schaltzustand und durch Anlegen einer zweiten Schaltspannung einer zweiten Polarität in einen zweiten Schaltzustand versetzt werden, wobei die zweite Polarität der ersten Polarität entgegengerichtet ist, und wobei der Betrag der ersten und der zweiten Schaltspannung mindestens so groß ist, dass in der Schicht aus dem ferroelektrischen Material die Koerzitivfeldstärke des ferroelektrischen Materials überschritten wird. Die erste und die zweite Schaltspannung werden auch als erste bzw. zweite Schreibspannung bezeichnet.

Dabei genügt zum Umpolen der Polarisation des ferroelektrischen Materials ein entsprechender Gleichspannungs-Puls, d.h. es ist keine ständig anliegende Spannung erforderlich. Nach Anlegen einer äußeren Gleichspannung an die beiden Elektroden ist der Polarisationszustand der ferroelektrischen Schicht stabilisiert, da durch die als Isolatorschicht wirkende dielektrische Schicht hindurch keine Leckströme zum Abbau der Polarisationsladung fließen können.

Bei Vorhandensein einer halbleitenden Schicht wird die Gesamtkapazität der Kapazitätsdiode zudem durch die Kapazität der Raumladungszone der halbleitenden Schicht bestimmt, wobei dieser Kapazitätsanteil insbesondere abhängig von auf das halbleitende Material auftreffender Strahlung sein kann.

Die Kapazitätscharakteristik der Kapazitätsdiode variiert mit deren Schaltzustand, wobei z.B. die Kapazitätsdiode in dem bzw. ausgehend von dem ersten Schaltzustand eine andere Kapazitäts-Spannungs-Kennlinie (CV-Kennlinie) aufweist als in dem bzw. ausgehend von dem zweiten Schaltzustand. Die Kapazität C der Kapazitätsdiode bei einer Gleichspannung V kann auf bekannte Weise mittels Anlegens der Gleichspannung V an die beiden Elektroden und Überlagerns der Gleichspannung V mit einer Wechselspannung V_{ac} einer kleinen Amplitude erfasst werden, wobei die CV-Kennlinie mittels Durchfahrens der angelegten Gleichspannung V erfasst wird.

Insbesondere weist die CV-Kennlinie der Kapazitätsdiode mit optionaler halbleitender Schicht ein Minimum auf, wobei die Lage dieses Minimums mit dem Schaltzustand der Kapazitätsdiode variiert. So weist z.B. bei Vorgabe eines ersten und eines zweiten Schaltzustandes die CV-Kennlinie in bzw. ausgehend von dem ersten Schaltzustand ein Minimum M1=(U_{1,min}; C_{1,min}) und in bzw. ausgehend von dem zweiten Schaltzustand ein Minimum M2=(U_{2,min}; C_{2,min}) auf, wobei U_{i,min} den Gleichspannungswert und C_{i,min} den Kapazitätswert des jeweiligen Minimums bezeichnen (i=1, 2). Dabei sind die Spannungswerte U_{1,min} und U_{2,min} betragsmäßig wesentlich kleiner als die erste und die zweite Schaltspannung (d.h. bei den Spannungen U_{1,min} und U_{2,min} genügt der über der ferroelektrischen Schicht resultierende Spannungsabfall nicht zum Überschreiten der Koerzitivfeldstärke).

Indem die Kapazitätsdiode unter Veränderung ihrer Kapazitätscharakteristik mittels eines Gleichspannungspulses zwischen unterschiedlichen Schaltzuständen hin- und hergeschaltet werden kann, wobei aufgrund der als Isolator fungierenden dielektrischen Schicht zum Umschalten kein Stromfluss erforderlich ist, kann die Kapazität der Kapazitätsdiode mit geringem Energieverbrauch eingestellt werden. Indem mittels der dielektrischen Schicht Leckströme, die zu einem Abbau der Polarisationsladung der ferroelektrischen Schicht führen würden, unterbunden sind, ist der eingestellte Schaltzustand zeitstabil bzw. nichtflüchtig.

Gemäß einer Ausführungsform beträgt die Dicke der dielektrischen Schicht mindestens 5 nm, bevorzugt mindestens 50 nm. Durch eine derartige Dicke der dielektrischen Schicht ist ein elektrischer Stromfluss durch dieselbe hindurch zuverlässig unterbunden. Zudem ist durch eine derart hinreichend hohe Dicke sichergestellt, dass die Verschiebung des Ladungsschwerpunkts (bzw. die damit einhergehende Kapazitätsänderung) zuverlässig messtechnisch erfassbar ist.

Die ferroelektrische Schicht weist im polarisierten Zustand (d.h. nach Anlegen der Koerzitivfeldstärke) an ihrer Grenzfläche bzw. Randfläche eine materialabhängige Polarisations-Flächenladungsdichte (d.h. Polarisationsladung pro Fläche) auf. Die dielektrische Schicht weist eine vorgegebene Volumenladungsdichte (d.h. elektrische Ladung pro Volumen) geladener Störstellen auf.

Die Materialien und Dicken der ferroelektrischen Schicht und der dielektrischen Schicht können derart gewählt sein, dass der Betrag des Produkts aus der Volumenladungsdichte und der Dicke der dielektrischen Schicht maximal gleich dem Betrag der Polarisations-Flächenladungsdichte der ferroelektrischen Schicht ist. Dadurch ist eine besonders ausgeprägte Variation des Ladungsschwerpunkts in der dielektrischen Schicht in Abhängigkeit vom Polarisationszustand der ferroelektrischen Schicht ermöglicht.

Es kann insbesondere vorgesehen sein, dass die Dicken (und Materialien) der ferroelektrischen Schicht und der dielektrischen Schicht derart auf die erste bzw. zweite Schaltspannung abgestimmt sind, dass die ferroelektrische Schicht nach Anlegen der ersten bzw. zweiten Schaltspannung an ihrer Grenzfläche eine erste bzw. zweite Polarisations-Flächenladungsdichte aufweist (wobei diese beiden Flächenladungsdichten identisch sein können), und wobei die Dicke der dielektrischen Schicht derart eingestellt ist, dass das Produkt aus der Volumenladungsdichte und der Dicke der dielektrischen Schicht betragsmäßig maximal gleich dem kleineren der beiden Werte der ersten und der zweiten Polarisations-Flächenladungsdichte ist.

Als Halbleitermaterialien mit einer elektronischen Bandlücke im IR-VIS-UV-Spektralbereich können z.B. Silizium (Si), Germanium (Ge), Galliumarsenid (GaAs), Galliumnitrid (GaN), Galliumphosphid (GaP), Siliziumkarbid (SiC), Zinktellurid (ZnTe) und Zinkoxid (ZnO) verwendet werden. Die elektronische Bandlücke beträgt bei Raumtemperatur für Silizium 1.10 eV, für Germanium 0.75 eV, für Galliumarsenid 1.43 eV, für Galliumnitrid 3.37 eV, für Galliumphosphid 2.26 eV, für Siliziumkarbid 2.39-2.33 eV, für Zinktellurid 2.40 eV und für Zinkoxid 3.37 eV.

Als dielektrisches Material (vorliegend auch als Isolator bezeichnet) können z.B. low-k Isolatoren mit einer statischen Dielektrizitätszahl kleiner als die statische Dielektrizitätszahl von Siliziumdioxid (SiO₂) verwendet werden. Zu den low-k Isolatoren zählen z.B. Wasserstoff-Silsesquioxan, Polyimide und Silicagele. Die statische Dielektrizitätszahl beträgt für Wasserstoff-Silsesquioxan 2.9-3.1, für Polyimide 3.1-3.4 und für Silicagele 2.0-2.5.

Es kann auch vorgesehen sein, als Dielektrikum bzw. Isolatoren mit moderaten statischen Dielektrizitätszahlen z.B. Siliziumdioxid (SiO₂), Siliziumnitrid (Si₃N₄), Siliziumoxinitrid (SiOₓN_{y}) und Aluminiumoxid (Al₂O₃) oder Kombinationen davon zu verwenden. Die statische Dielektrizitätszahl beträgt für Siliziumdioxid 3.8, für Siliziumnitrid 5.5-9.4, für Siliziumoxinitrid 3.9-7.0 und für Aluminiumoxid 7.6-8.6.

Als weitere Isolatoren mit moderaten statischen Dielektrizitätszahlen können z.B. Hafniumoxid (HfO₂), Tantaloxid (Ta₂O₅) und Titandioxid (TiO₂) oder Kombinationen davon vorgesehen sein. Die statische Dielektrizitätszahl beträgt für Hafniumoxid 25, für Tantaloxid 24-28 und für Titandioxid 50-100.

Als ferroelektrische Materialien können z.B. Wismutheisenoxid (BiFeO₃), Yttriummanganoxid (YMnO₃) und/oder Wismuthmanganoxid (BiMnO₃) vorgesehen sein. Oberhalb der ferroelektrischen Curietemperatur werden ferroelektrische Materialien piezoelektrisch und verlieren ihren Polarisationszustand. Die ferroelektrische Curietemperatur (Polarisationsladung) beträgt bei BiFeO₃ 1100 K (90-95 µC/cm²), bei YMnO₃ 913 K- 1270 K (12 µC/cm²) und bei BiMnO₃ 105 K (9 µC/cm²).

Die Kapazitätscharakteristik der Kapazitätsdiode kann durch darauf auftreffende Strahlung beeinflusst werden, sodass durch Erfassen der vorliegenden Kapazitätscharakteristik Rückschlüsse auf die Strahlung gezogen werden können.

Gemäß der Erfindung wird demgemäß ein Detektor zum Erfassen von Strahlung bereitgestellt, der eine oder mehrere Kapazitätsdioden gemäß den vorstehend erläuterten Ausführungen als Detektorelemente bzw. Messgrößen-Aufnehmer aufweist. Die Strahlung kann dabei durch Teilchenstrahlung oder elektromagnetische Strahlung gegeben sein.

Der Detektor kann (z.B. mittels einer entsprechend ausgebildeten Steuereinheit) derart ausgebildet sein, dass von ihm eine Schaltspannung zwischen die erste und die zweite Elektrode anlegbar ist, wobei der Betrag der Schaltspannung mindestens so groß ist, dass bei Anliegen der Schaltspannung an den beiden Elektroden in der Schicht aus dem ferroelektrischen Material die Koerzitivfeldstärke des ferroelektrischen Materials überschritten wird, sodass die Kapazitätsdiode mittels Anlegens der Schaltspannung in einen Vorgabe-Schaltzustand mit einer definierten Kapazitätscharakteristik versetzbar ist.

Der Detektor ist zum Erfassen der Kapazität oder Kapazitätscharakteristik der Kapazitätsdiode und Charakterisieren der Strahlung basierend auf der erfassten Kapazität bzw. Kapazitätscharakteristik ausgebildet. Das Erfassen der vorliegenden Kapazitätscharakteristik der Diode kann analog zu der oben beschriebenen Vorgehensweise erfolgen. Das Charakterisieren kann z.B. mittels Vergleichs der erfassten Kapazitätscharakteristik mit einer oder mehreren als Referenz hinterlegten Referenz-Charakteristiken erfolgen.

So wurde z.B. festgestellt, dass die Lage der Minima M1=(U_{1,min}; C_{1,min}) bzw. M2=(U_{2,min}; C_{2,min}) der CV-Kennlinie der Kapazitätsdiode mit der Wellenlänge und Intensität von auf die Kapazitätsdiode auftreffender elektromagnetischer Strahlung variiert. Zudem variiert die Lage der Minima M1=(U_{1,min}; C_{1,min}) bzw. M2=(U_{2,min}; C_{2,min}) der CV-Kennlinie der Kapazitätsdiode mit der Art, Energie und Anzahl von auf die Kapazitätsdiode auftreffenden Teilchen. Somit kann der Detektor (z.B. mittels der Steuereinheit) derart ausgebildet sein, dass von ihm basierend auf der erfassten Kapazitätscharakteristik, insbesondere basierend auf der Lage des Minimums der CV-Kennlinie der Kapazitätsdiode, die auf die Kapazitätsdiode auftreffende Wellen- oder Teilchenstrahlung charakterisiert wird. Es kann insbesondere vorgesehen sein, dass der Detektor bzw. die Steuereinheit derart ausgebildet ist, dass davon die Lage des Minimums der CV-Kennlinie der Kapazitätsdiode erfasst wird und basierend auf der erfassten Lage des Minimums die Wellenlänge und/oder die Intensität von auf die Kapazitätsdiode auftreffender elektromagnetischer Strahlung erfasst wird.

Als ein weiteres Beispiel ist für eine vorgegebene Wellenlänge λ der elektromagnetischen Strahlung der Spannungswert U_{1,min} bzw. U_{2,min} des Minimums der Kapazitäts-Spannungs-Kennlinie konstant, wobei sich jedoch mit zunehmender Strahlungsintensität der Kapazitätswert (C_{1,min} bzw. C_{2,min}) des jeweiligen Minimums zu größeren Werten verschiebt. Somit kann für eine vorgegebene Wellenlänge die Strahlungsintensität mittels Erfassens des Kapazitätswertes des Minimums der CV-Kennlinie erfasst werden. Diesbezüglich kann z.B. vorgesehen sein, der Kapazitätsdiode ein Spektralfilter zum Herausfiltern der vorgegebenen Wellenlänge vorzuschalten.

Somit erfolgt bei der Verwendung der Kapazitätsdiode als Detektorelement ausschließlich eine kapazitive, stromlose Messung, was gegenüber einer Strommessung einen wesentlich geringeren Energieverbrauch und wesentlich kürzere Zugriffszeiten ermöglicht sowie die zum Betreiben erforderliche Kühlleistung reduziert.

Der Detektor kann mehrere der Kapazitätsdioden in einem Crossbar-Array aufweisen. Gekreuzte Leiterbahnen (Crossbar-Array) stellen eine neue Bauteilarchitektur in der Halbleitertechnologie dar und können als strukturierte, elektrisch leitende Kontakte an der Oberseite und an der Unterseite der funktionalen Schichten verwendet werden. In einem Crossbar-Array ist die strukturierte oder ganzflächige funktionale Schicht zwischen den gekreuzten Leiterbahnen eingebettet. Möchte man die Kapazität einer Zelle auslesen, wird an die beiden Leiterbahnen, an deren Kreuzungspunkt die Zelle liegt, eine Auslesespannung der Testfrequenz f_{ac} angelegt.

Eine Kapazitätsdiode gemäß den vorstehenden Erläuterungen kann hergestellt werden, indem das ferroelektrische Material zunächst bei Raumtemperatur in der amorphen Phase auf die dielektrische Schicht aufgebracht (z.B. mittels Magnetronsputtern oder mittels Gepulster Laserplasma Abscheidung) und anschließend mittels optischen Energieeintrags (z.B. mittels Blitzlampen oder Laser) rekristallisiert wird. Dadurch kann der Wärmeeintrag in das Dielektrikum und ggf. das Halbleitermaterial gering gehalten werden und eine Schädigung desselben vermieden werden.

Es kann vorgesehen sein, die dielektrische Schicht vor dem Aufbringen des ferroelektrischen Materials zu strukturieren, sodass beim Aufbringen des ferroelektrischen Materials dasselbe ebenfalls entsprechend strukturiert wird.

Es kann zudem vorgesehen sein, die Anzahl der geladenen Störstellen in der dielektrischen Schicht vor dem Aufbringen des ferroelektrischen Materials zu erhöhen, beispielsweise an den Kreuzungspunkten einer Cross-Bar-Array-Struktur mittels Ionenimplantation, sodass die Kapazitäts-Spannungs-Charakteristik der verschiedenen Kreuzungspunkte ebenfalls entsprechend unterschiedlich ist.

Die Kapazitätsdiode kann somit z.B. ein Mehrschichtsystem in Form einer Elektrode-Ferroelektrikum-Dielektrikum-Elektrode-Struktur aufweisen, wobei die Kapazitätsdiode eine nichtflüchtige und bestrahlungssensitive Kapazität aufweist. Zwischen dem Dielektrikum und der zweiten Elektrode ist zudem bevorzugt ein Halbleitermaterial angeordnet, sodass im Folgenden lediglich die Struktur bei Vorhandensein der halbleitenden Schicht näher erläutert wird. Die dielektrische Schicht bzw. Isolatorschicht ist insbesondere als dicke Isolatorschicht mit einer hohen Anzahl an elektrisch geladenen Störstellen im Isolator ausgebildet, die ferroelektrische Schicht zwischen Elektrode und Isolator dient zur räumlichen Stabilisierung und Positionierung der geladenen Störstellen im Isolator.

Nach Anlegen einer äußeren Spannung an die Elektrode-Ferroelektrikum-Isolator-Halbleiter-Elektrode-Struktur ist der Polarisationszustand der ferroelektrischen Schicht stabilisiert, da durch die dicke Isolatorschicht hindurch keine Leckströme zum Abbau der Polarisationsladung fließen können. Die CV-Charakteristiken der Elektrode-Ferroelektrikum-Isolator-Halbleiter-Elektrode-Struktur sind ohne und mit Bestrahlung quantifizierbar, da der Ladungsschwerpunkt der geladenen Störstellen im Isolator in Abhängigkeit vom Polarisationszustand der ferroelektrischen Schicht stabilisiert ist.

Die Anordnung wird als kapazitiver Strahlungsdetektor verwendet. Die Anordnung kann, z.B. unter Verwendung mindestens einer für elektromagnetische Wellen und/oder Teilchen transparenten Elektrode, bei Bestrahlung mit elektromagnetischen Wellen und/oder Teilchen als Detektor für diese verwendet werden. Auf die Anordnung auftreffende elektromagnetische Wellen ändern vorrangig die Besetzung der Störstellen im Isolator und die Besetzung der Dotieratome im Halbleiter. Auf die Anordnung auftreffende Teilchen können den Polarisationszustand der ferroelektrischen Schicht, die Konzentration und/oder die Verteilung der Störstellen in der Isolatorschicht sowie die Dotierung des Halbleiters ändern. Als Anwendung können z.B. nichtflüchtige photokapazitive Sensoren, Photodetektoren, CCD-/CMOS-Sensoren und Teilchendetektoren vorgesehen sein.

Als Vorteile der erläuterten Technologie gegenüber z.B. herkömmlichen CCD-Sensoren ergeben sich z.B. (a) die Nutzung einer nichtflüchtigen Kapazität als direkter Ausleseparameter anstatt einer Ladung oder eines Stromes (dadurch z.B. um Faktor von ca. 1000 schnelleres Auslesen und um Faktor von ca. 1000 geringerer Energieverbrauch möglich), (b) die Wellenlängen- und Intensitätsabhängigkeit des Ausleseparameters, damit eine höhere Sensitivität und weniger Rauschen, im Gegensatz zur derzeitigen Notwendigkeit der Verwendung von Farbfiltern, (c) die Möglichkeit zum gleichzeitigen, unabhängigen Auslesen der Kapazität an jeder einzelnen Detektorzelle anstatt eines seriellen, zeilenweisen Auslesens, damit eine Erhöhung der Auslesegeschwindigkeit, und (d) eine einfache Herstellung der ferroelektrischen Schicht durch Abscheidung von amorphem ferroelektrischen Material (z.B. BiFeO₃) und anschließender Rekristallisation (z.B. mittels Blitzlampenausheilung).

Die Erfindung wird nachfolgend anhand von Ausführungsbeispielen mit Bezug auf die beiliegenden Figuren veranschaulicht, wobei gleiche oder ähnliche Merkmale mit gleichen Bezugszeichen versehen sind; hierbei veranschaulichen schematisch:
Fig. 1a, 1b: den Aufbau und Zustand eines Mehrschichtsystems mit nichtflüchtiger und bestrahlungssensitiver Kapazität bei Anlegen einer Spannung V1, deren Betrag nicht zum Überschreiten der Koerzitivfeldstärke ausreicht;
Fig. 2a, 2b: den Aufbau und Zustand des Mehrschichtsystems nach Anlegen einer Spannung +V2, deren Betrag zum Überschreiten der Koerzitivfeldstärke ausreicht;
Fig. 3a, 3b: den Aufbau und Zustand des Mehrschichtsystems nach Anlegen einer Spannung -V2, deren Betrag zum Überschreiten der Koerzitivfeldstärke ausreicht;
Fig. 4a, 4b1, 4b2, 4c: den Aufbau und Zustand des Mehrschichtsystems nach Anlegen einer Spannung +V2, +V2ⱼ und -V2, -V2ⱼ sowie die jeweils zugehörige Kapazitäts-Spannungs-Charakteristik;
Fig. 5a, 5b1, 5b2, 5c: die Stabilität der Kapazität des Mehrschichtsystems an den Spannungspunkten mit den Kapazitäts-Minima M1 und M2;
Fig. 6a, 6b, 6c: den Aufbau und Zustand des Mehrschichtsystems bei Anlegen einer Spannung +V2 und -V2 bei Bestrahlung mit elektromagnetischen Wellen sowie die zugehörigen Kapazitäts-Spannungs-Charakteristiken;
Fig. 7a, 7b1, 7b2, 7c: die Stabilität der Kapazität des Mehrschichtsystems an den Spannungspunkten mit den Kapazitäts-Minima M1 und M2 bei Bestrahlung mit einer monochromatischen elektromagnetischen Welle;
Fig. 8a, 8b, 8c: den Aufbau und Zustand des Mehrschichtsystems bei Anlegen einer Spannung +V2 und -V2 bei Bestrahlung mit Teilchen sowie eine mögliche Strukturierung einer für Teilchen transparenten Elektrode an der Vorderseite des Mehrschichtsystems;
Fig. 9a, 9b, 9c: ein Mehrschichtsystem in Crossbar-Array-Struktur sowie eine Möglichkeit der Strukturierung der verwendeten Kontakte und des ferroelektrischen Materials;
Fig. 10a, 10b, 10c: ein weiteres Mehrschichtsystem in Crossbar-Array-Struktur sowie eine Möglichkeit der Strukturierung der verwendeten Kontakte und des ferroelektrischen Materials und des Isolators;
Fig. 11a, 11b, 11c: ein weiteres Mehrschichtsystem in Crossbar-Array-Struktur sowie eine Möglichkeit der Strukturierung der verwendeten Kontakte und des ferroelektrischen Materials; und
Fig. 12a, 12b, 12c: ein weiteres Mehrschichtsystem in Crossbar-Array-Struktur sowie eine Möglichkeit der Strukturierung der verwendeten Kontakte und des ferroelektrischen Materials und des Isolators.

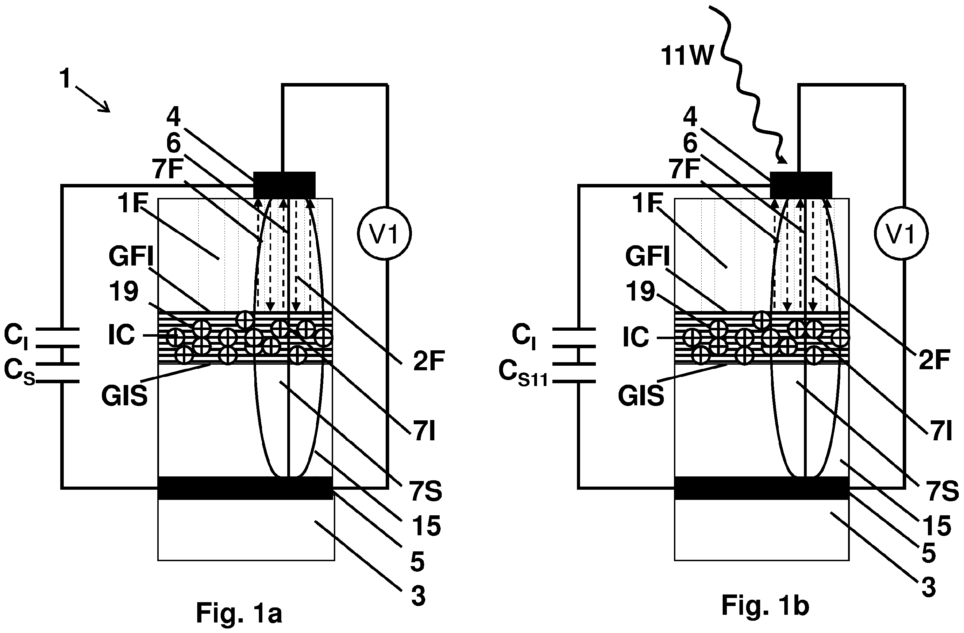

Die Figuren 1a und 1b zeigen den prinzipiellen Aufbau eines Mehrschichtsystems bzw. einer Kapazitätsdiode 1 in Form des Mehrschichtsystems. Die Kapazitätsdiode 1 weist eine Schichtanordnung mit einer Schicht 1F aus einem ferroelektrischen Material (hier als Beispiel BiFeO₃), einer elektrisch isolierenden Schicht 19 aus einem dielektrischen Material (hier als Beispiel SiN), und einer Schicht 15 aus einem dotierten Halbleitermaterial (hier als Beispiel p-Si) auf. Die dielektrische Schicht 19 weist geladene Störstellen IC auf (hier als Beispiel positiv geladene Störstellen in Form von Fremdatomen, welche während des Aufbringes der BiFeO₃-Schicht in die SiN-Schicht eingebracht wurden).

Die Kapazitätsdiode 1 weist zudem eine erste Elektrode 4 und eine zweite Elektrode 5 auf, wobei die erste Elektrode 4 kontaktierend an der ferroelektrischen Schicht 1F und die zweite Elektrode 5 kontaktierend an der dotierten Halbleiterschicht 15 angebracht ist, sodass die Kapazitätsdiode 1 in Richtung von der ersten Elektrode 4 zu der zweiten Elektrode 5 hin nacheinander die ferroelektrische Schicht 1F, die dielektrische Schicht bzw. Isolatorschicht 19, und die dotierte Halbleiterschicht 15 aufweist.

Die Gesamtkapazität des Mehrschichtsystems setzt sich aus der nichtflüchtigen Kapazität C_{I} der Isolatorschicht 19 und der nichtflüchtigen und bestrahlungsabhängigen Kapazität C_{S}, C_{S11} der Raumladungszone des dotierten Halbleiters 15 zusammen (wobei Cₛ die Kapazität der Raumladungszone ohne auftreffende Strahlung 11 und Cₛ₁₁ die Kapazität der Raumladungszone bei auftreffender Strahlung 11 kennzeichnet). In den Figuren sind die Kapazitäten C_{I}, Cₛ, Cₛ₁₁ als Ersatzschaltbild veranschaulicht.

Bei Anlegen einer Spannung V1 an den Frontkontakt 4 und den zugehörigen Gegenkontakt 5 wird hauptsächlich die Kapazität C_{S}, C_{S11} der Raumladungszone des dotierten Halbleiters 15 geändert. Das Mehrschichtsystem kann auf einem Substrat 3 aufgebracht sein.

Ferroelektrische Stoffe sind immer auch piezoelektrisch. Ohne eine von außen angelegte Spannung V1 bildet sich in dem ferroelektrischen (piezoelektrischen) Material 1F spontan (nicht spontan) eine elektrische Polarisation aus, die jedoch lokal variiert. Die ferroelektrische Schicht 1F ist in dem Bereich 2F von dem Frontkontakt 4 kontaktiert. Mit einer von außen angelegten Spannung V1 bildet sich in dem Bereich 2F des ferroelektrischen (piezoelektrischen) Materials 1F spontan (nicht spontan) eine elektrische Polarisation aus (in den Figuren veranschaulicht durch die gestrichelt dargestellten Pfeile im Bereich 2F der ferroelektrischen Schicht 1F). Aufgrund der elektrischen Polarisation im Bereich 2F des ferroelektrischen Materials 1F bilden sich in dem Mehrschichtsystem im Bereich des ferroelektrischen (piezoelektrischen) Materials 2F elektrische Feldlinien 7F, im Bereich des Isolators 19 elektrische Feldlinien 7I, und im Bereich des dotierten Halbleiters 15 elektrische Feldlinien 7S aus.

Wenn das elektrische Feld, das durch den Abfall der angelegten Spannung V1 über dem Bereich 2F der ferroelektrischen Schicht hervorgerufen wird, kleiner ist als die Koerzitivfeldstärke des ferroelektrischen Materials, so ist das ferroelektrische Material 1F auch im Bereich 2F nicht homogen elektrisch polarisiert und die elektrischen Feldlinien 7F sind ungerichtet. In diesem Fall hat das elektrische Feld 7F im ferroelektrischen Bereich 2F keinen Einfluss auf die Verteilung der Ladungen IC im Isolator 19. Die Verteilung der Ladungen IC im Isolator 19 ist bei ausreichend großen elektrischen Polarisationsladungen des ferroelektrischen Materials 1F zwar stabilisiert, jedoch ist der Ladungsschwerpunkt der Ladungen IC im Isolator 19 weder in Richtung der Grenzfläche GFI zwischen der ferroelektrischen Schicht 1F und der Isolatorschicht 19 noch in Richtung der Grenzfläche GIS zwischen der Isolatorschicht 19 und dem dotierten Halbleitermaterial 15 verschoben.

Figur 1a veranschaulicht den Fall ohne Bestrahlung, Figur 1b den Fall mit Bestrahlung der Kapazitätsdiode 1 mit elektromagnetischen Wellen 11W. Bei Bestrahlung des Mehrschichtsystems mit elektromagnetischen Wellen 11W mit einer Energie größer als die elektronische Bandlücke des dotierten Halbleiters 15 ändert sich die Kapazität des dotierten Halbleiters 15 von C_{S} auf C_{S11}.

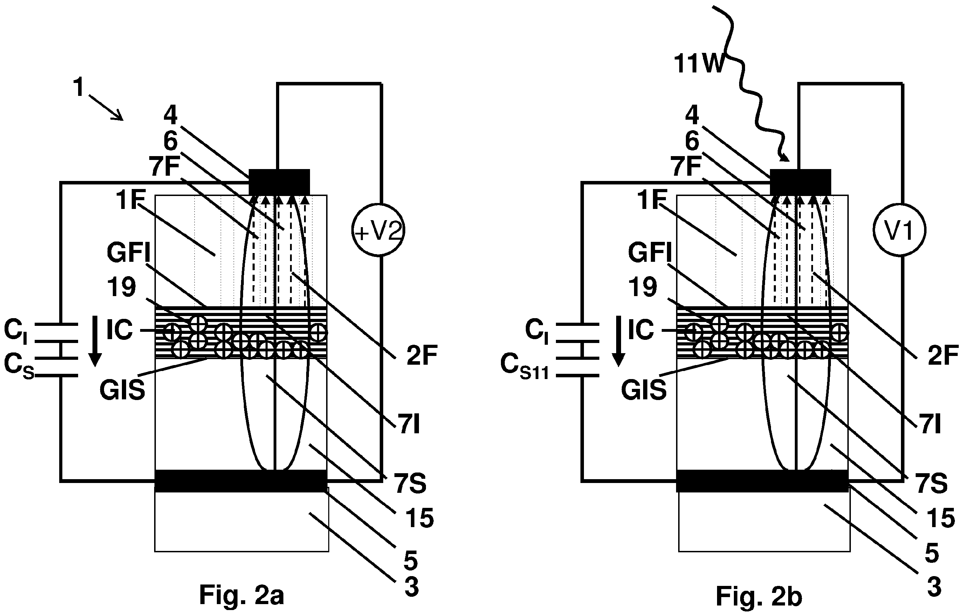

Figur 2a zeigt das Mehrschichtsystem bei Anlegen einer positiven Spannung +V2 an den Frontkontakt 4, wobei (durch entsprechendes Einstellen des Betrags der Spannung) das elektrische Feld, das durch den Abfall der angelegten Spannung +V2 über dem Bereich 2F der ferroelektrischen Schicht 1F hervorgerufen wird, größer als die Koerzitivfeldstärke des ferroelektrischen Materials ist, so dass das ferroelektrische Material 1F im Bereich 2F homogen elektrisch polarisiert ist und die elektrischen Feldlinien 7F alle in die gleiche Richtung zeigen. In diesem Fall beeinflusst das elektrische Feld 7F im Bereich 2F des ferroelektrischen Materials 1F die Verteilung der Ladungen IC im Isolator 19. Vorliegend sind als Beispiel gemäß Figur 2a durch Anlegen der Spannung +V2 mit dem positiven Pol an der ersten Elektrode 4 und dem negativen Pol an der zweiten Elektrode 5 die positiven Ladungen IC in Richtung zu der Grenzfläche GIS zwischen Isolatorschicht 19 und dotiertem Halbleitermaterial 15 verschoben, was mit einer entsprechenden Verschiebung des zugehörigen Ladungsschwerpunktes einhergeht. Die Verschiebung des Ladungsschwerpunktes der geladenen Störstellen in der dielektrischen Schicht 19 ist in den Figuren durch den links neben der dielektrischen Schicht 19 dargestellten Pfeil veranschaulicht. Die Positionierung der geladenen Störstellen IC im Isolator 19 ist bei ausreichend großer elektrischer Polarisationsladung des ferroelektrischen Materials 1F stabilisiert. Die Positionierung der geladenen Störstellen IC im Isolator 19 bleibt solange stabilisiert, wie eine von außen angelegte Spannung V1 die elektrische Polarisation im Bereich 2F des ferroelektrischen Materials 1F nicht ändert.

Figur 2b veranschaulicht, dass sich nach Anlegen einer Spannung +V2 auch bei Bestrahlung des Mehrschichtsystems mit elektromagnetischen Wellen 11W mit einer Energie größer als die elektronische Bandlücke des dotierten Halbleiters 15 der Ladungsschwerpunkt der geladenen Störstellen IC in Richtung zu der Grenzfläche GIS hin verschiebt und dass sich die Kapazität des dotierten Halbleiters 15 von C_{S} auf C_{S11} ändert.

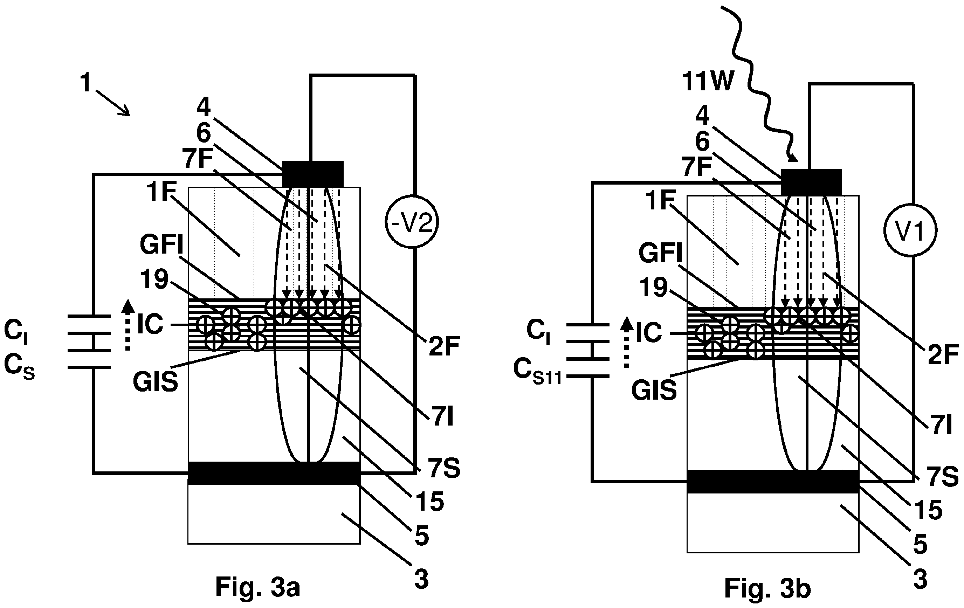

Figur 3a zeigt das Mehrschichtsystem bei Anlegen einer negativen Spannung -V2 an den Frontkontakt 4, wobei das elektrische Feld, das durch den Abfall der angelegten Spannung -V2 über dem Bereich 2F hervorgerufen wird, größer als die Koerzitivfeldstärke des ferroelektrischen Materials ist, so dass das ferroelektrische Material 1F im Bereich 2F homogen elektrisch polarisiert ist und die elektrischen Feldlinien 7F alle in die gleiche Richtung zeigen. In diesem Fall beeinflusst das elektrische Feld 7F im Bereich 2F des ferroelektrischen Material 1F die Positionierung der geladenen Störstellen IC im Isolator 19. Vorliegend sind als Beispiel gemäß Figur 3a durch Anlegen der Spannung -V2 mit dem negativen Pol an der ersten Elektrode 4 und dem positiven Pol an der zweiten Elektrode 5 die positiven Ladungen IC in Richtung zu der Grenzfläche GFI zwischen der ferroelektrischen Schicht 1F und der Isolatorschicht 19 verschoben. Die Verteilung der Ladungen IC im Isolator 19 ist bei ausreichend großen elektrischen Polarisationsladungen des ferroelektrischen Materials 1F stabilisiert. Die Verteilung der Ladungen IC im Isolator 19 bleibt solange stabilisiert, wie eine von außen angelegte Spannung V1 die elektrische Polarisation im Bereich 2F des ferroelektrischen Materials 1F nicht ändert.

Figur 3b veranschaulicht, dass sich nach Anlegen einer Spannung -V2 auch bei Bestrahlung des Mehrschichtsystems mit in Richtung zu der Grenzfläche GFI hin verschobenen Ladungen IC mit elektromagnetischen Wellen 11W mit einer Energie größer als die elektronische Bandlücke des dotierten Halbleiters 15 die Kapazität des dotierten Halbleiters 15 von C_{S} auf C_{S11} ändert.

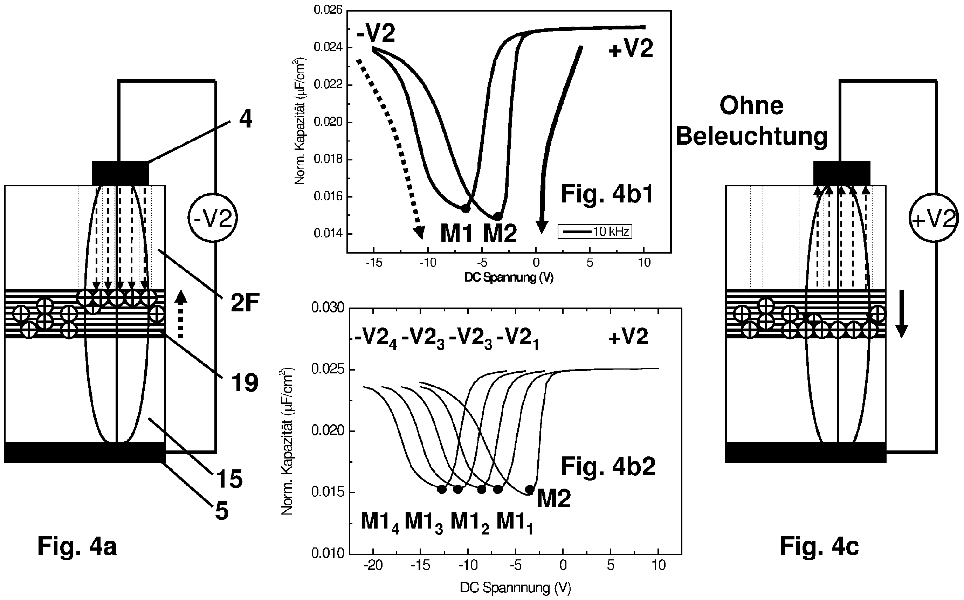

Figur 4b1 zeigt zwei unterscheidbare Kapazitäts-Spannungs (CV)-Charakteristiken des Mehrschichtsystems ohne Bestrahlung in Abhängigkeit vom Startpunkt der von außen angelegten Spannung V. Zum Erfassen der Kapazität C bei einer Spannung V werden die Elektroden des Mehrschichtsystems mit der Gleichspannung V beaufschlagt und diese Gleichspannung mit einer Wechselspannung V_{ac} überlagert, aus der Antwort des Systems wird auf bekannte Weise die Kapazität ermittelt.

Wird zuerst eine negative Spannung -V2 zwischen dem Vorderseitenkontakt 4 und dem Rückseitenkontakt 5 angelegt (Fig. 3a und Fig. 4a), sind beispielsweise positive Ladungen IC in Richtung der Grenzfläche GFI zwischen Isolatorschicht 19 und dem Bereich 1F und/oder Bereich 2F verschoben und die Flachbandspannung ist kleiner als im Fall von gleichmäßig verteilten Ladungen IC im Isolator 19. Die entsprechende CV-Kurve weist ein Minimum M1 = (U_{1,min}; C_{1,min}) auf.

Wird zuerst eine positive Spannung +V2 zwischen dem Vorderseitenkontakt 4 und dem Rückseitenkontakt 5 angelegt (Fig. 2a und Fig. 4c), sind beispielsweise positive Ladungen IC in Richtung der Grenzfläche GIS zwischen Isolatorschicht 19 und dotiertem Halbleitermaterial 15 verschoben und die Flachbandspannung ist größer als im Fall von gleichmäßig verteilten Ladungen IC im Isolator 19. Die entsprechende CV-Kurve weist ein Minimum M2 = (U_{2,min}; C_{2,min}) auf.

Der Unterschied in den Flachbandspannungen für die beiden möglichen extremalen Verteilungen der Ladungen IC im Isolator 19 ist umso größer, je größer die elektrische Polarisationsladung des ferroelektrischen Materials, je größer die Konzentration der Ladungen IC im Isolator 19 und je dicker der Isolator 19 ist. Vorliegend beträgt die Dicke der Isolatorschicht 19 als Beispiel 50 nm, wodurch eine zuverlässige elektrische Isolierung und eine zuverlässig erfassbare geometrische Verschiebung des Ladungsschwerpunkts der geladenen Störstellen IC gewährleistet sind. Zudem sind die Dicken der ferroelektrischen Schicht 1F und der dielektrischen Schicht 19 derart gewählt, dass das Produkt aus der Volumenladungsdichte geladener Störstellen IC und der Dicke der dielektrischen Schicht 19 betragsmäßig maximal gleich der Polarisations-Flächenladungsdichte der ferroelektrischen Schicht 1F im polarisierten Zustand ist, wodurch eine ausgeprägte Variation des Ladungsschwerpunkts der geladenen Störstellen IC in der dielektrischen Schicht 19 in Abhängigkeit vom Polarisationszustand der ferroelektrischen Schicht 1F ermöglicht ist.

Figur 4b2 zeigt die CV-Charakteristiken der Kapazitätsdiode 1 für mehrere unterschiedliche Schaltspannungen -V2ⱼ (mit j = 1, 2, 3, 4) - die zwar ein und dieselbe Polarität, jedoch unterschiedliche Spannungsbeträge aufweisen - zusammen mit einer CV-Charakteristik für eine Schaltspannung +V2 mit einer gegenüber den Schaltspannungen -V2ⱼ entgegengesetzten Polarität. Wie aus der Figur ersichtlich, weisen die CV-Kennlinien für die Schaltspannungen -V2ⱼ deutlich voneinander abgrenzbare Minima M1ⱼ auf, wohingegen die CV-Kennlinie für die Schaltspannung +V2 ein Minimum M2 aufweist.

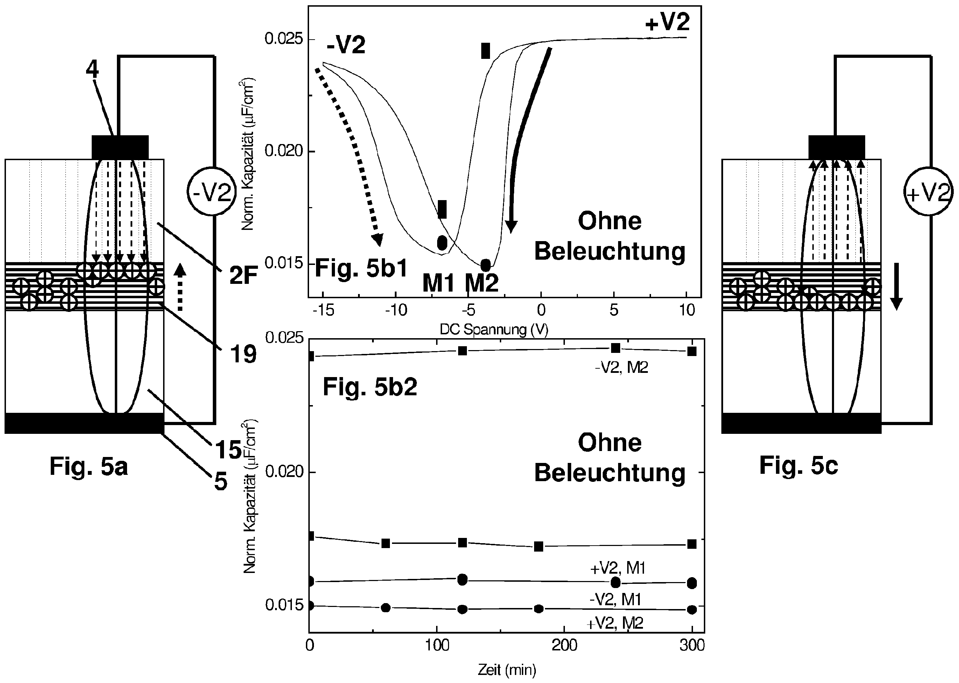

Die Figuren 5a bis 5c zeigen, wie durch einmaliges Anlegen eines Spannungspulses der Amplitude -V2 (Fig. 5a) oder der Amplitude +V2 (Fig. 5c), bei der die Koerzitivfeldstärke in der ferroelektrischen Schicht 1F überschritten wird, die beiden möglichen extremalen Verteilungen der Ladungen IC im Isolator 19 eingestellt werden. Ein solcher Spannungspuls wird im Folgenden als Schalt- oder Schreibspannung U_{write} bezeichnet. Figur 5b1 zeigt, dass beim Anlegen einer Gleichspannung (dc-Spannung) mit dem kleinen Wert U_{1,min} bzw. U_{2,min}, bei dem die CV-Kurve das Minimum M1 bzw. das Minimum M2 hat, die Kapazität des Mehrschichtsystems nicht geändert wird.

Wird beispielsweise der Schreibspannungspuls -V2 angelegt, dann weist die CV-Kurve des Mehrschichtsystems das Minimum M1 auf und die mit einer Lesespannung U_{read} = U_{1,min} des Minimums M1 ausgelesene Kapazität ist kleiner als die mit einer Lesespannung U_{read} = U_{2,min} des Minimums M2 ausgelesene Kapazität. Wird hingegen der Schreibspannungspuls +V2 angelegt, dann weist die CV-Kurve des Mehrschichtsystems das Minimum M2 auf und die mit einer Lesespannung U_{read} = U_{2,min} des Minimums M2 ausgelesene Kapazität ist kleiner als die mit einer Lesespannung U_{read} = U_{1,min} des Minimums M1 ausgelesene Kapazität. Figur 5b2 zeigt, dass die beiden möglichen extremalen Verteilungen der Ladungen IC im Isolator 19 nichtflüchtig eingestellt werden und durch Anlegen der Lesespannung auf einer Zeitskala größer als 300 min nicht verändert werden.

Somit kann die Kapazitätsdiode 1 mittels Anlegens der ersten Schaltspannung -V2 in einen stabilen ersten Schaltzustand und mittels Anlegens der zweiten Schaltspannung +V2 in einen stabilen zweiten Schaltzustand versetzt werden, wobei diese beiden Schaltzustände unterschiedliche Kapazitätscharakteristiken aufweisen. Die Schaltspannungen werden auch als Schreibspannungen bezeichnet.

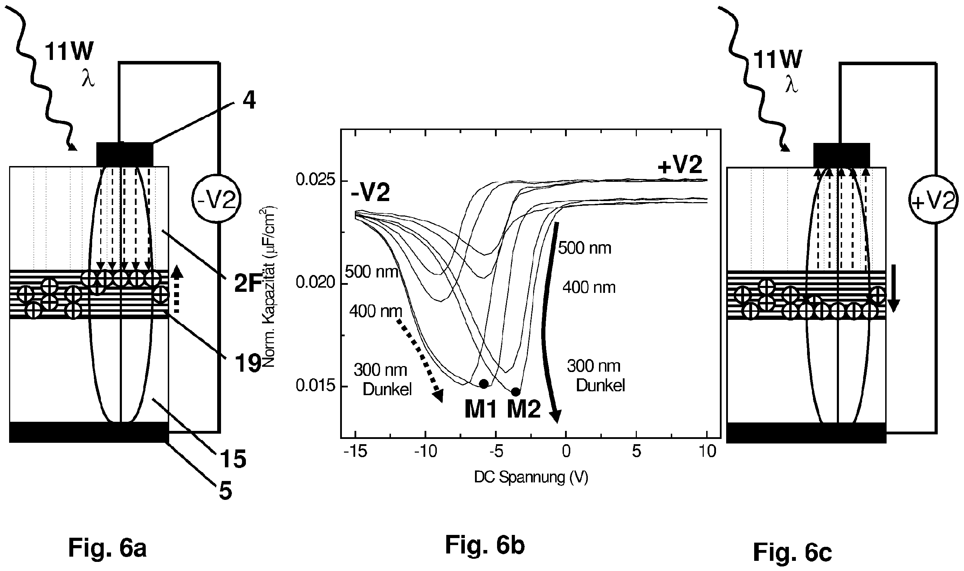

Die Figuren 6a bis 6c veranschaulichen die Kapazitäts-Spannungs (CV)-Charakteristiken des Mehrschichtsystems im ersten und im zweiten Schaltzustand bei Bestrahlung mit elektromagnetischen Wellen 11W in Abhängigkeit vom Startpunkt der von außen angelegten Spannung V für unterschiedliche Wellenlängen der auftreffenden Strahlung. Wird zuerst eine negative Spannung -V2 zwischen dem Vorderseitenkontakt 4 und dem Rückseitenkontakt 5 angelegt (Fig. 6a), sind beispielsweise positive Ladungen IC in Richtung zu der Grenzfläche GFI zwischen der ferroelektrischen Schicht 1F und der Isolatorschicht 19 verschoben und die Flachbandspannung ist kleiner als im Fall von gleichmäßig verteilten Ladungen IC im Isolator 19. Die entsprechende CV-Kurve weist ein Minimum M1 auf und die Position des Minimums hängt von der Wellenlänge λ des verwendeten Lichtes ab (Fig. 6b).

Wird zuerst eine positive Spannung +V2 zwischen dem Vorderseitenkontakt 4 und dem Rückseitenkontakt 5 angelegt (Fig. 6c), sind beispielsweise positive Ladungen IC in Richtung zu der Grenzfläche GIS zwischen der Isolatorschicht 19 und dem dotiertem Halbleitermaterial 15 verschoben und die Flachbandspannung ist größer als im Fall von gleichmäßig verteilten Ladungen IC im Isolator 19. Die entsprechende CV-Kurve weist ein Minimum M2 auf und die Position des Minimums hängt von der Wellenlänge λ des verwendeten Lichtes ab (Fig. 6b).

Beispielsweise werden bei Verwendung von BiFeO₃ als ferroelektrisches Material, SiN als Isolator mit positiven Ladungen (in Form von geladenen Störstellen), und von p-leitendem Silizium als Halbleitermaterial das Minimum M1 und das Minimum M2 bei Bestrahlung mit monochromatischem Licht gleicher Intensität und verschiedener Wellenlänge λ mit zunehmender Wellenlänge λ zu kleineren Spannungswerten hin verschoben (Fig. 6b). Als ein anderes Beispiel liegt bei Verwendung von BiFeO₃ als ferroelektrisches Material, SiN als Isolator mit positiven Ladungen, und p-leitendem Silizium als Halbleitermaterial sowohl das Minimum M1 als auch das Minimum M2 bei Bestrahlung mit monochromatischem Licht verschiedener Intensität und gleicher Wellenlänge λ bei gleichbleibenden Spannungswerten U_{1,min} bzw. U_{2,min}, jedoch ist der Kapazitätswert C_{1,min} bzw. C_{2,min} mit zunehmender Intensität zu höheren Werten verschoben (nicht gezeigt). Der Kapazitätswert am Minimum M1 und am Minimum M2 kann durch Variation der Lichtintensität in einem Wertebereich zwischen dem kleinsten Kapazitätswert (keine Bestrahlung) und einem größtmöglichen Kapazitätswert (gesättigte Bestrahlung) eingestellt werden.

Zum besseren Erfassen der Strahlung können z.B. die Topelektrode 4 und/oder die Gegenelektrode 5 für die zu erfassende Strahlung transparent gestaltet sein.

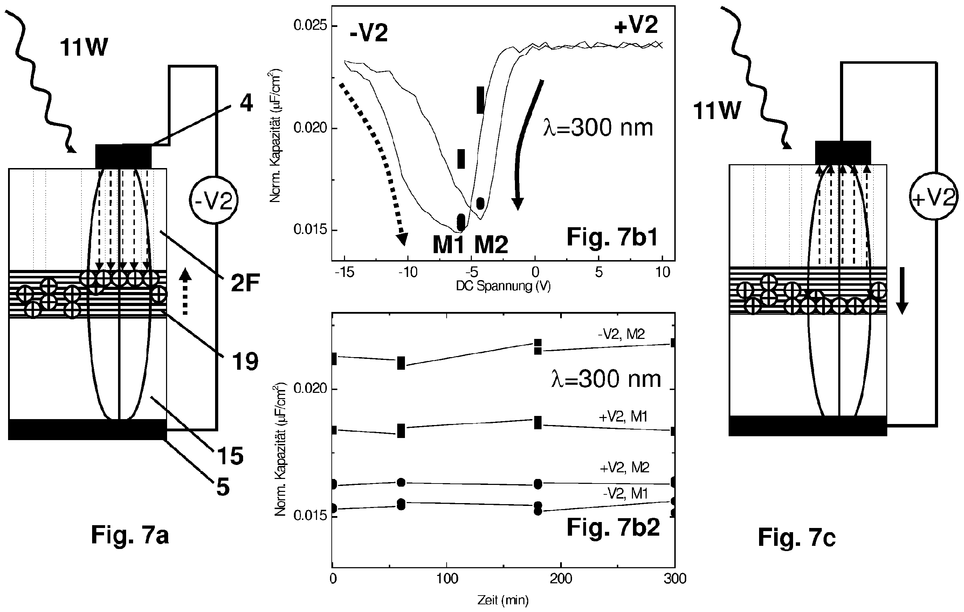

Die Figuren 7a bis 7c zeigen, wie auch bei Bestrahlung mit monochromatischem Licht (hier: der Wellenlänge λ=300 nm) und konstanter Lichtintensität durch einmaliges Anlegen eines Spannungspulses der Amplitude -V2 (Fig. 7a) oder der Amplitude +V2 (Fig. 7c) die beiden möglichen extremalen Verteilungen der Ladungen IC im Isolator 19 eingestellt werden. Dieser Spannungspuls wird wieder als Schreibspannung U_{write} bezeichnet. Fig. 7b1 zeigt, dass beim Anlegen einer Gleichspannung mit dem kleinen Wert U_{1,min} bzw. U_{2,min}, bei dem die CV-Kurve bei Bestrahlung mit λ=300 nm das Minimum M1 oder das Minimum M2 hat, die Kapazität des Mehrschichtsystems nicht geändert wird. Wird beispielsweise der Schreibspannungspuls -V2 angelegt, dann weist die CV-Kurve des Mehrschichtsystems das Minimum M1 auf und die mit einer Lesespannung U_{read}=U_{1,min} des Minimums M1 ausgelesene Kapazität ist kleiner als die mit einer Lesespannung U_{read}=U_{2,min} des Minimums M2 ausgelesene Kapazität. Wird beispielsweise der Schreibspannungspuls +V2 angelegt, dann weist die CV-Kurve des Mehrschichtsystems das Minimum M2 auf und die mit einer Lesespannung U_{read}=U_{2,min} des Minimums M2 ausgelesene Kapazität ist kleiner als die mit einer Lesespannung U_{read}=U_{1,min} des Minimums M1 ausgelesene Kapazität. Figur 7b2 zeigt, dass auch bei Bestrahlung mit λ=300 nm die beiden möglichen extremalen Verteilungen der Ladungen IC im Isolator 19 nichtflüchtig eingestellt werden und durch Anlegen der Lesespannung auf einer Zeitskala größer als 300 min nicht verändert werden.

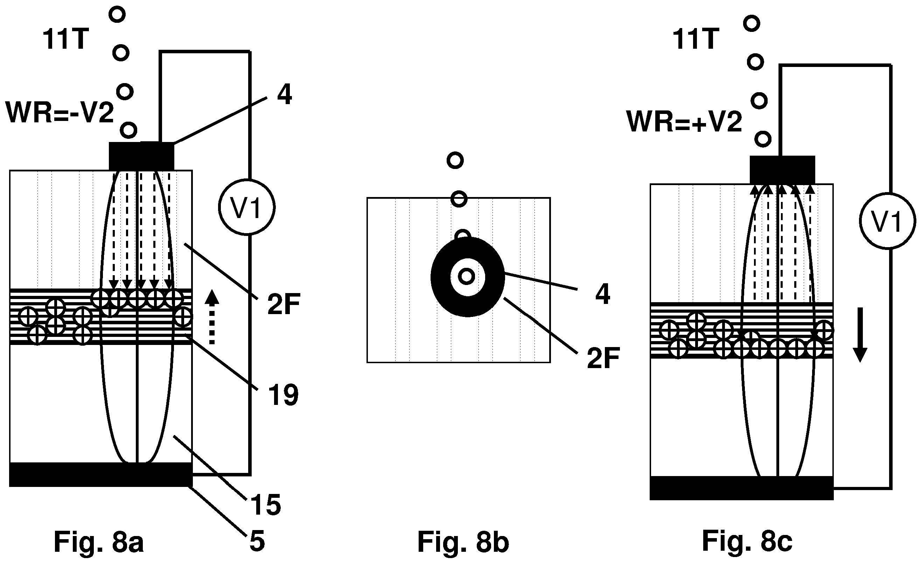

Die Figuren 8a bis 8c zeigen ein Mehrschichtsystem mit einem für Teilchen durchlässigen Topkontakt 4 (Fig. 8b). Durch einmaliges Anlegen eines Schreibpulses U_{write} der Amplitude -V2 (Fig. 8a) oder der Amplitude +V2 (Fig. 8c) werden wieder die beiden möglichen extremalen Verteilungen der Ladungen IC im Isolator 19 eingestellt. Jede Änderung der Ladungen IC im Isolator 19 bei Bestrahlung mit Teilchen 11T - beispielsweise der Anzahl, des Ladungszustandes und/oder der Verteilung - beeinflusst die beiden unterscheidbaren Kapazitäts-Spannungs-Kurven des Mehrschichtsystems der Kapazitätsdiode 1.

Geladene Teilchen können im elektrischen Feld 7F des ferroelektrischen Materials 2F beschleunigt oder abgebremst werden. Des Weiteren kann die Position des Ladungsschwerpunktes der Störstellen IC im Isolator durch das Einbringen zusätzlicher geladener Teilchen im Isolator kontrolliert beeinflusst werden. Beispielsweise können Seltene Erd-Ionen durch Ionenimplantation in den Isolator vor dem Aufbringen der ferroelektrischen Schicht 1F in den Isolator eingebracht werden. Ändern die zu detektierenden Teilchen den Ladungszustand der Seltenen-Erd-Ionen, dann ist auch die extremale Verteilung der Ladungen IC im Isolator 19 geändert.

Demgemäß kann die Kapazitätsdiode 1 als Detektorelement zum Erfassen von darauf auftreffender Strahlung fungieren, wobei das Detektorelement mittels Beaufschlagens mit der ersten Schaltspannung -V2 oder der zweiten Schaltspannung +V2 in einen definierten Zustand versetzbar ist, und wobei mittels Erfassens und Auswertens der vorliegenden Kapazitätscharakteristik (z.B. der Lage des Minimums der CV-Kennlinie) die auf die Kapazitätsdiode auftreffende Strahlung charakterisierbar ist.

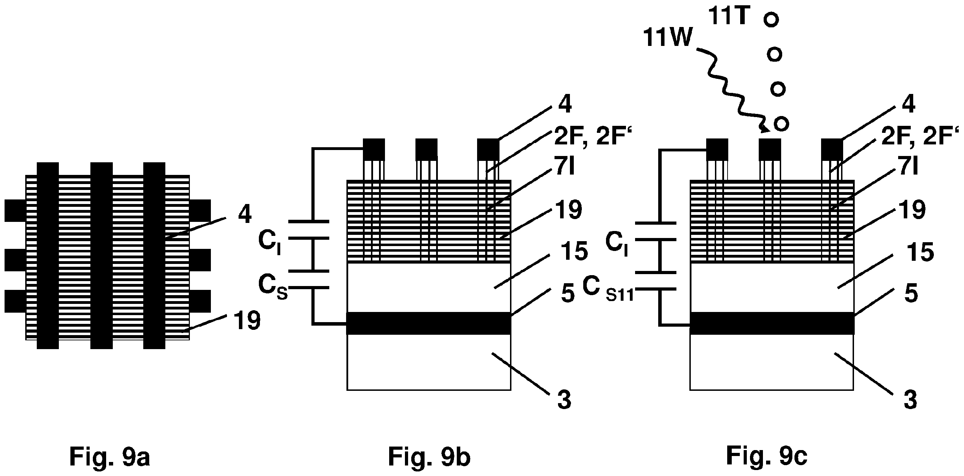

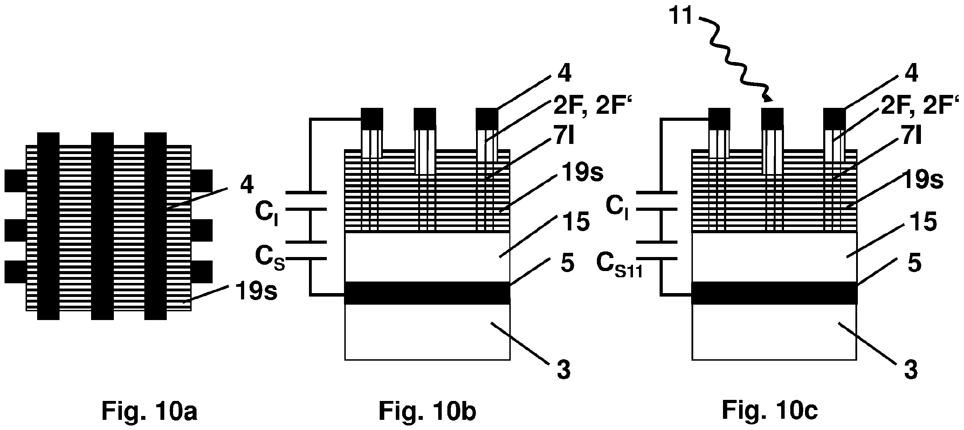

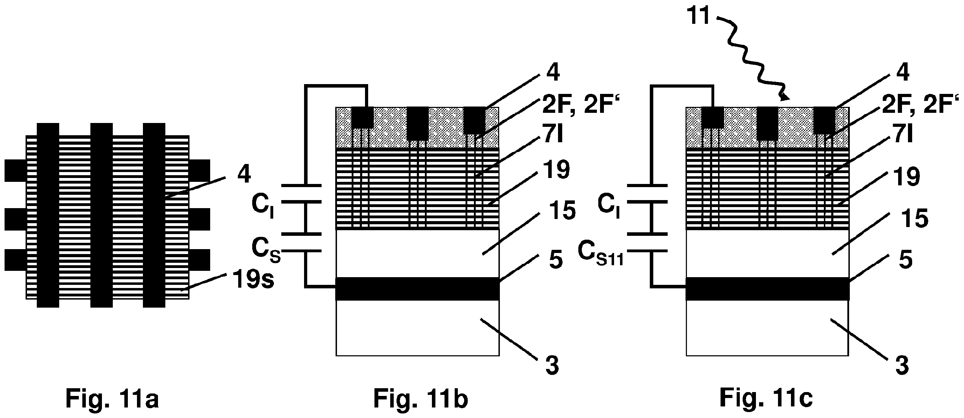

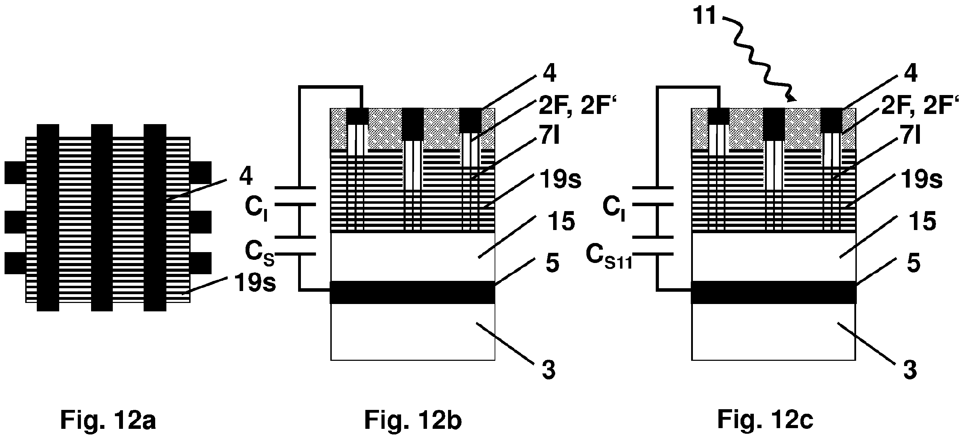

Die Kontrolle der Ladungen IC im Isolator des Mehrschichtsystems gelingt lokal, wenn sowohl der Topkontakt 4 als auch der Bottomkontakt 5 strukturiert ausgeführt werden. Die Figuren 9 bis 12 zeigen jeweils Cross-Bar-Arrays mit strukturierten leitenden Oberflächenkontakten 4 und zugehörigen gegenüberliegenden, um 90° gedrehten Gegenkontakten 5. Der Vorteil dieser Anordnung der Definition des Cross-Bar-Arrays ist, dass an jedem Kreuzungspunkt gleichzeitig die nichtflüchtige, bestrahlungssensitive Kapazität lokal ausgelesen werden kann.

Die dargestellte Anordnung umfasst jeweils einen Halbleiter 15, einen Isolator 19 und eine ferroelektrische Schicht 1F. Die ferroelektrische Schicht 1F kann durch Dünnschichtwachstum, beispielsweise mittels Magnetronsputtern oder mittels Gepulster Laserplasma Abscheidung bei Züchtungstemperaturen zwischen 350°C und 1000 °C hergestellt werden. Vorteilhaft ist es jedoch, die ferroelektrische Schicht 1F bei Raumtemperatur mittels Magnetronsputtern oder mittels Gepulster Laserplasma Abscheidung in der amorphen Phase herzustellen und anschließend mittels FLA (Flash Lamp Annealing) auf der ms-Zeitskala zu rekristallisieren. Dadurch ist der Wärmeeintrag in den dotierten Halbleiter und in das Substrat 3 signifikant reduziert. An den Halbleiter ist eine Rückseitenelektrode 5 und an die ferroelektrische Schicht eine Vorderseitenelektrode 4 angebracht. Der Isolator 19 enthält eine signifikante Zahl geladener Störstellen IC. Die Dicke des Isolators beträgt mindestens 1 nm. Die Dicke des Isolators liegt bevorzugt im Bereich zwischen 50 nm und 500 nm. Die ferroelektrische Schicht 1F kann durch Anlegen einer Spannung zwischen die Vorderseitenelektrode 4 und die Rückseitenelektrode 5 derart elektrisch polarisiert werden, dass positive (negative) Polarisationsladungen an der Grenzfläche zwischen ferroelektrischer Schicht und Halbleiter und negative (positive) Polarisationsladungen zwischen ferroelektrischer Schicht und Isolator ausgebildet werden. Die Polariationsladungen in der ferroelektrischen Schicht verursachen einen Drift der geladenen Störstellen IC. Der Ladungsschwerpunkt der gedrifteten Störstellen ist stabil. Der Ladungsschwerpunkt ist für beide Polarisationszustände der ferroelektrischen Schicht unterschiedlich. Die Kapazitäts-Spannungs-Kurve (C-V) der gesamten Anordnung ähnelt der C-V-Kurve einer Metall-Isolator-Halbleiter-Struktur und hängt von der Lage des Ladungsschwerpunktes im Isolator ab. Der Ladungszustand der Störstellen in der Grenzfläche zwischen ferroelektrischer und dielektrischer Schicht GFI und in der Grenzfläche zwischen dielektrischer und halbleitender Schicht GIS ist in der Kapazitätsdiode stabil. In dem als Flachbandspannung einer Metall-Isolator-Halbleiter-Struktur bezeichneten Spannungsbereich ist der Unterschied zwischen den beiden Kapazitäts-Spannungs-Kurven besonders groß. Im Spannungsbereich der Akkumulation und Inversion nähern sich die Werte der beiden C-V-Kurven an.

Gemäß dem vorstehenden Beispiel weist das Mehrschichtsystem der Kapazitätsdiode eine Materialabfolge Elektrode, BiFeO₃ als Ferroelektrikum, SiN als Dielektrikum, p-Si als dotierter Halbleiter, Elektrode auf. Es kann jedoch z.B. auch vorgesehen sein, anstelle von BiFeO₃ als Ferroelektrikum YMnO₃ als Ferroelektrikum zu verwenden. Die Elektroden können z.B. aus Aluminium oder Gold bestehen; insbesondere kann vorgesehen sein, dass die erste Elektrode aus Aluminium und die zweite Elektrode aus Gold besteht.

Die in den Figuren veranschaulichten Anordnungen werden, z.B. unter Verwendung mindestens einer für elektromagnetische Wellen und/oder Teilchen transparenten Elektrode 4,5, bei Bestrahlung mit elektromagnetischen Wellen und/oder Teilchen als Detektor zum Erfassen derselben verwendet. Bei monochromatischer Beleuchtung ändern sich bei Änderung der Wellenlänge der elektromagnetischen Welle die Spannungswerte U_{1,min} und U_{2,min} der C-V-Kurven, bei denen jeweils die Minima der beiden C-V-Kurven auftreten. Eine Erhöhung der Lichtintensität bei gleichbleibender Wellenlänge erhöht den Wert der Kapazität C_{1,min} bzw. C_{2,min} bei den Spannungswerten U_{1,min} bzw. U_{2,min} der C-V-Kurven, bei denen jeweils die Minima der beiden C-V-Kurven auftreten, ohne den Spannungswert des jeweiligen Minimums zu ändern. Auf die Anordnung auftreffende Teilchen können sowohl den Polarisationszustand der ferroelektrischen Schicht, die Konzentration und Verteilung der Störstellen in der Isolatorschicht, sowie die Dotierung des Halbleiters ändern. Vorteilhaft ist es, wenn der Polarisationszustand der ferroelektrischen Schicht durch Bestrahlung mit Teilchen geändert wird. Durch einen wiederholten Schreibpuls kann die Polarisation der ferroelektrischen Schicht nach der Teilchendetektion wieder hergestellt werden.

Vorteilhaft bei der Anordnung als Einzelpixel ist z.B., dass die Änderung der Photokapazität der spektralen Response entspricht und bei konstanter Beleuchtungsstärke im Vergleich zur Standard-CCD nur von der Wellenlänge der elektromagnetischen Welle abhängt, nicht jedoch von der Signalintegrationszeit (Akkumulation von photogenerierten Ladungen in Standard-CCD und Messung der Photokapazität der beleuchteten Anordnung).

Vorteilhaft bei der Anordnung in einem Pixel-Array ist z.B., dass das Auslesen der Photokapazität jedes Pixels gleichzeitig bei einer Testfrequenz von bis zu mehreren MHz erfolgen kann. Dadurch können bis zu 1-10 Millionen Bilder pro Minute aufgenommen werden (wohingegen das zeilenweise Auslesen der photogenerierten Ladungen in Standard-CCDs die Frequenz limitiert, mit der die Information ausgelesen werden kann). Die laterale Auflösung der Anordnung ist aufgrund der Isolierbarkeit jedes einzelnen Pixels von den benachbarten Pixeln beim parallelen Auslesen der Photokapazität größer als die laterale Auflösung einer Standard-CCD (insbesondere da Pixel einer Zeile des Pixel-Arrays nicht elektrisch verbunden sein müssen). Die Photokapazität eines Pixels geht nach Abschalten der Beleuchtung mit elektromagnetischen Wellen wieder auf den Ausgangswert, d.h. auf den Wert der Photokapazität des Pixels im Dunkelfall, zurück (wohingegen bei Standard-CCDs eine Reset-Operation ausgeführt werden muss, um einen Überlauf an akkumulierten photogenerierten Ladungen zu verhindern).

### Liste der verwendeten Bezugszeichen

- 1: Kapazitätsdiode
- 1F: Schicht aus ferroelektrischem Material
- 2F: von der ersten Elektrode überdeckter Abschnitt der ferroelektrischen Schicht
- 3: Substrat
- 4: erste Elektrode / Frontkontakt
- 5: zweite Elektrode / Gegenkontakt
- 7F: elektrische Feldlinien in der ferroelektrischen Schicht
- 7I: elektrische Feldlinien in der dielektrischen Schicht
- 7S: elektrische Feldlinien in der halbleitenden Schicht
- 11: Strahlung
- 11W: Strahlung aus elektromagnetischen Wellen
- 11T: Strahlung aus Teilchen
- 15: Schicht aus dotiertem Halbleitermaterial
- 19: Schicht aus dielektrischem Material
- IC: geladene Störstellen in der dielektrischen Schicht
- C_{I}: Kapazität der dielektrischen Schicht
- C_{S}: Kapazität der Raumladungszone der Halbleiterschicht ohne Strahlung
- C_{S11}: Kapazität der Raumladungszone der Halbleiterschicht mit Strahlung
- GFI: Grenzfläche zwischen ferroelektrischer und dielektrischer Schicht
- GIS: Grenzfläche zwischen dielektrischer und halbleitender Schicht
- -V2, -V2ⱼ: von außen an die beiden Elektroden der Kapazitätsdiode angelegte Spannung mit negativem Pol am Frontkontakt und einem Betrag, mit dem die Koerzitivfeldstärke des ferroelektrischen Materials der überschritten wird,
- +V2, +V2ⱼ: von außen an die beiden Elektroden der Kapazitätsdiode angelegte Spannung mit positivem Pol am Frontkontakt und einem Betrag, mit dem die Koerzitivfeldstärke des ferroelektrischen Materials der überschritten wird,
- M1, M1ⱼ: Minimum der Kapazitätsspannungscharakteristik der Kapazitätsdiode nach Anlegen einer Spannung -V2, -V2ⱼ an die Elektroden der Kapazitätsdiode,
- M2, M2ⱼ: Minimum der Kapazitätsspannungscharakteristik der Kapazitätsdiode nach Anlegen der Spannung +V2, +V2ⱼ an die Elektroden der Kapazitätsdiode,
- U_{1,min} U_{1j,min}: dc Lesespannung zum Auslesen der Kapazität am Minimum M1, M1ⱼ der Kapazitätscharakteristik
- U_{2,min} U_{2j,min}: dc Lesespannung zum Auslesen der Kapazität am Minimum M1, M1ⱼ der Kapazitätscharakteristik

## Patentansprüche

1. Detektor zum Erfassen von Strahlung (11), aufweisend mindestens eine Kapazitätsdiode (1) als Detektorelement, wobei die mindestens eine Kapazitätsdiode aufweist:
- eine erste Elektrode (4) und eine zweite Elektrode (5), und
- eine kontaktierend zwischen der ersten (4) und der zweiten (5) Elektrode angeordnete Schichtanordnung, wobei
- die Schichtanordnung in Richtung von der ersten (4) zu der zweiten (5) Elektrode hin nacheinander eine Schicht (1F) aus einem ferroelektrischen Material und eine weitere Schicht (19) aufweist,
**dadurch gekennzeichnet, dass**
- die weitere Schicht (19) eine elektrisch isolierende Schicht (19) aus einem dielektrischen Material ist, wobei die Schicht (19) aus dem dielektrischen Material elektrisch geladene Störstellen (IC) aufweist, und
- der Detektor zum Erfassen der Kapazität der Kapazitätsdiode (1) und Charakterisieren der Strahlung (11) basierend auf der erfassten Kapazität ausgebildet ist.

2. Detektor nach Anspruch 1, wobei die Strahlung (11) Teilchenstrahlung (11T) oder elektromagnetische Strahlung (11W) ist.

3. Detektor nach Anspruch 1 oder 2, wobei der Detektor derart ausgebildet ist, dass von ihm eine elektrische Spannung (+V2, -V2) zwischen die erste (4) und die zweite (5) Elektrode anlegbar ist, wobei der Betrag der elektrischen Spannung mindestens so groß ist, dass in der Schicht (1F) aus dem ferroelektrischen Material die Koerzitivfeldstärke des ferroelektrischen Materials überschritten wird.

4. Detektor nach einem der Ansprüche 1 bis 3, wobei die Schichtanordnung in Richtung von der ersten (4) zu der zweiten (5) Elektrode hin nacheinander die Schicht (1F) aus dem ferroelektrischen Material, die Schicht (19) aus dem dielektrischen Material und eine Schicht (15) aus einem dotierten Halbleitermaterial aufweist.

5. Detektor nach einem der Ansprüche 1 bis 4, wobei die Dicke der Schicht (19) aus dem dielektrischen Material mindestens 5 nm beträgt.

## Claims

1. Detector for detecting radiation (11), comprising at least one variable-capacitance diode (1) as detector element, the at least one variable-capacitance diode comprising:
- a first electrode (4) and a second electrode (5), and
- a layer arrangement arranged in contact-making fashion between the first electrode (4) and the second electrode (5),
- the layer arrangement comprising, in succession in a direction from the first electrode (4) towards the second electrode (5), a layer (1F) composed of a ferroelectric material and a further layer (19),
**characterized in that**
- the further layer (19) is an electrically insulating layer (19) composed of a dielectric material, the layer (19) composed of the dielectric material having electrically charged impurities (IC), and
- the detector being configured for detecting the capacitance of the variable-capacitance diode (1) and characterizing the radiation (11) on the basis of the detected capacitance.

2. Detector according to Claim 1, wherein the radiation (11) is particle radiation (11T) or electromagnetic radiation (11W).

3. Detector according to Claim 1 or 2, wherein the detector is configured in such a way that it is able to apply an electrical voltage (+V2, -V2) between the first electrode (4) and the second electrode (5), wherein the absolute value of the electrical voltage is at least high enough that the coercive field strength of the ferroelectric material is exceeded in the layer (1F) composed of the ferroelectric material.

4. Detector according to any of Claims 1 to 3, wherein the layer arrangement comprises, in succession in a direction from the first electrode (4) towards the second electrode (5), the layer (1F) composed of the ferroelectric material, the layer (19) composed of the dielectric material and a layer (15) composed of a doped semiconductor material.

5. Detector according to any of Claims 1 to 4, wherein the thickness of the layer (19) composed of the dielectric material is at least 5 nm.

## Revendications

1. Détecteur destiné à la détection de rayonnement (11), ledit détecteur comportant au moins une diode à capacité variable (1) comme élément détecteur, l'au moins une diode à capacité variable comportant :
- une première électrode (4) et une deuxième électrode (5), et
- un ensemble de couches disposé au contact entre la première (4) et la deuxième (5) électrode,
- l'ensemble de couches comportant, successivement dans la direction allant de la première (4) à la deuxième (5) électrode, une couche (1F) en matériau ferroélectrique et une autre couche (19),
**caractérisé en ce que**
- l'autre couche (19) est une couche électriquement isolante (19) en matériau diélectrique, la couche (19) en matériau diélectrique présentant des imperfections chargées électriquement (IC), et
- le détecteur est conçu pour détecter la capacité de la diode à capacité variable (1) et caractériser le rayonnement (11) sur la base de la capacité détectée.

2. Détecteur selon la revendication 1, le rayonnement (11) étant un rayonnement de particules (11T) ou un rayonnement électromagnétique (11W).

3. Détecteur selon la revendication 1 ou 2, le détecteur étant conçu de manière à pouvoir appliquer une tension électrique (+V2, -V2) entre la première (4) et la deuxième (5) électrode, la valeur absolue de la tension électrique étant au moins telle que l'intensité du champ coercitif du matériau ferroélectrique soit dépassée dans la couche (1F) en matériau ferroélectrique.

4. Détecteur selon l'une des revendications 1 à 3, l'ensemble de couches comportant, successivement dans la direction allant de la première (4) à la deuxième (5) électrode, la couche (1F) en matériau ferroélectrique, la couche (19) en matériau diélectrique et une couche (15) en matériau semi-conducteur dopé.

5. Détecteur selon l'une des revendications 1 à 4, l'épaisseur de la couche (19) en matériau diélectrique étant d'au moins 5 nm.
